# EUROPÄISCHE PATENTSCHRIFT

(11) **EP 0 275 884 B1**
(45) Veröffentlichungstag und Bekanntmachung des Hinweises auf die Patenterteilung: **26.05.1993**
(21) Anmeldenummer: 88100197.8
(22) Anmeldetag: 08.01.1988
(51) Int. Cl.: G11C 8/00

(54) **Halbleiterspeicher mit wahlfreiem Zugriff über zwei getrennte Ein/Ausgänge**
Semiconductor memory randomly accessible over two separate input/outputs
Mémoire à semi-conducteurs accessible sur deux entrées et deux sorties différentes

(30) Priorität: 23.01.1987 DE 3701976
(43) Veröffentlichungstag der Anmeldung: 27.07.1988
(73) Patentinhaber: SIEMENS AKTIENGESELLSCHAFT, 80333 München (DE)
(72) Erfinder: Mattausch, Hans Jürgen, Dr. rer. nat., D-8011 Kirchheim (DE)

(56) Entgegenhaltungen:
- WO-A-84/04419
- GB-A- 2 097 623
- US-A- 4 633 105

## Beschreibung

Die Erfindung bezieht sich auf einen Halbleiterspeicher mit wahlfreiem Zugriff über zwei getrennte Ein/Ausgänge nach dem Oberbegriff des Patentanspruchs 1.

Ein derartiger, auch als "Dual-Port-RAM" bezeichneter Speicher ist aus dem Tagungsband der IEEE Custom Integrated Circuits Conference, Sept. 1982, S. 311-314 bekannt. Beim Betrieb eines solchen Speichers sind Konfliktsituationen möglich, falls z.B. in eine über beide Ein/Ausgänge gleichzeitig adressierte Speicherzelle zwei unterschiedliche Signale eingeschrieben werden sollen, weil dann ein unkontrollierbares Signal eingespeichert werden würde. Um das zu verhindern, müssen logische Gatterschaltungen vorgesehen werden, die eine gleichzeitige Adressierung ein und derselben Speicherzelle über beide Ein/Ausgänge verhindern.

Aus GB-A-2 097 623 ist ein Halbleiterspeicher mit wahlfreiem Zugriff über zwei getrennte Ein- und Ausgänge bekannt, der alle Merkmale des ersten Teils des Anspruchs 1 enthält. Dadurch daß die beiden Ein/Ausgänge nur abwechselnd wirksam geschaltet werden, wird die oben beschriebene Konfliktsituation vermieden.

Der Erfindung liegt die Aufgabe zugrunde, einen Halbleiterspeicher der eingangs genannten Art anzugeben, bei dem derartige Konfliktsituationen sicher vermieden werden können und wahlweise die Taktperiode verkleinert werden kann. Das wird erfindungsgemäß durch eine Ausbildung des Halbleiterspeichers nach dem Kennzeichen des Patentanspruchs 1 erreicht.

Die Patentansprüche 2 bis 5 sind auf bevorzugte Ausgestaltungen und Weiterbildungen der Erfindung gerichtet.

Die Erfindung wird nachfolgend anhand eines in der Zeichnung dargestellten, bevorzugten Ausführungsbeispiels näher erläutert. Dabei zeigt:
- Fig. 1: das Blockschaltbild eines Halbleiterspeichers,
- Fig. 2: die Prinzipschaltung einer Speicherzelle des Halbleiterspeichers nach Fig. 1,
- Fig. 3 und Fig. 4: Spannungs-Zeit-Diagramme zur Erläuterung von Fig. 1 und
- Fig. 5: ein bevorzugtes Ausführungsbeispiel einer Teilschaltung nach Fig. 1.

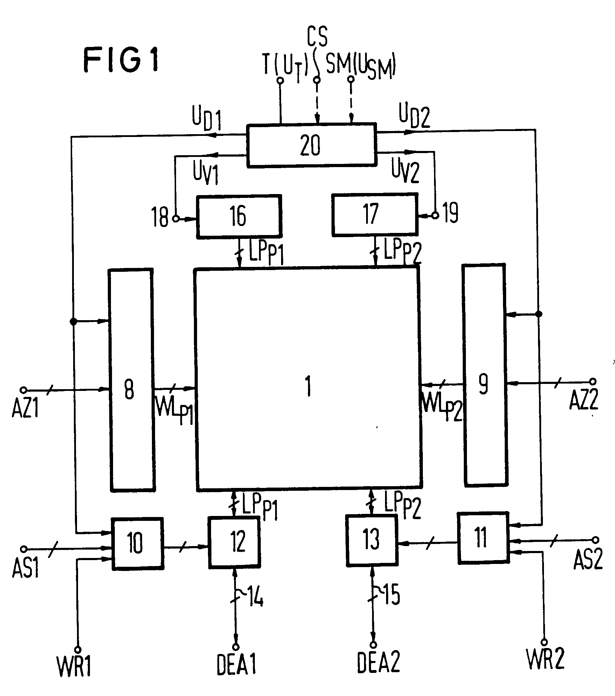

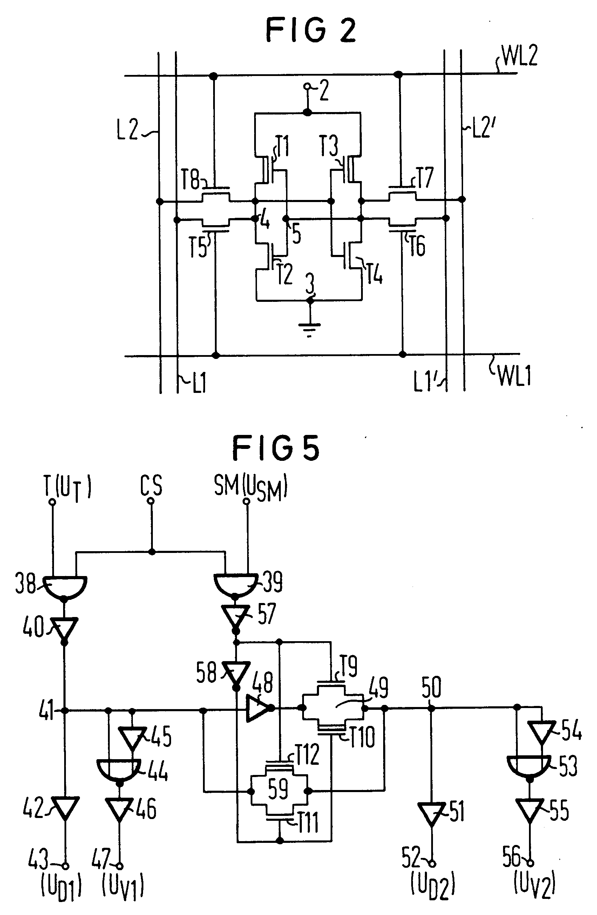

In Fig. 1 bezeichnet 1 ein Speicherfeld, das aus einer Vielzahl von z.B. nach Fig. 2 ausgebildeten, statischen Speicherzellen in komplementärer Schaltungstechnik aufgebaut ist. Jede dieser Speicherzellen weist gemäß Fig. 2 zwei kreuzgekoppelte Inverter auf, von denen der erste aus der Serienschaltung zweier Feldeffekttransistoren T1 und T2 besteht, der zweite aus der Serienschaltung zweier Feldeffekttransistoren T3 und T4. Die Sourceanschlüsse der p-Kanal-Transistoren T1 und T3 sind mit einem Anschluß 2 verbunden, der mit einer Versorgungsspannung von z.B. 5 V beschaltet ist. Die Sourceanschlüsse der n-Kanal-Transistoren T2 und T4 liegen an einem Anschluß 3, der mit dem Bezugspotential beschaltet ist. Die Drainanschlüsse von T1 und T2 sind in einem Knoten 4 miteinander verbunden, die Gateanschlüsse dieser Transistoren in einem Knoten 5. Zur Realisierung der Kreuzkopplung sind die Drainanschlüsse von T3 und T4 ebenfalls im Knoten 5 miteinander verbunden, die Gateanschlüsse von T3 und T4 im Knoten 4. Die Knoten 4 und 5 sind jeweils über die Source-Drain-Strecken von n-Kanal-Auswahltransistoren T5 und T6 mit Datenleitungen L1 und L1ʹ verbunden, sowie über die Source-Drain-Strecken von n-Kanal-Auswahltransistoren T8 und T7 mit Datenleitungen L2 und L2ʹ. Dabei werden die Gates von T5 und T6 über eine Wortleitung WL1 angesteuert, die Gates von T7 und T8 über eine Wortleitung WL2.

Die Speicherzellen sind im Speicherfeld 1 zeilen- und spaltenweise zusammengefaßt, und zwar derart, daß sämtliche Speicherzellen einer Zeile an gemeinsamen Wortleitungen WL1 und WL2 liegen, während sämtliche Speicherzellen einer Spalte gemeinsame Datenleitungspaare L1, L1ʹ und L2, L2ʹ aufweisen. Die Wortleitungen WL1 sämtlicher Zeilen des Speicherfeldes 1 sind in Fig. 1 mit WL_{P1} bezeichnet, die Wortleitungen WL2 sämtlicher Zeilen mit WL_{P2}. Die Datenleitungspaare L1, L1ʹ sämtlicher Spalten des Speicherfeldes sind mit LP_{P1} bezeichnet, die Datenleitungspaare L2, L2ʹ sämtlicher Spalten mit LP_{P2}. DEA1 bezeichnet einen ersten Ein/Ausgang für Daten, DEA2 einen zweiten. Ein Block 8 stellt die Zeilendecodierung für DEA1 dar, ein Block 9 die Zeilendecodierung für DEA2. Die Spaltendecodierungen für DEA1 und DEA2 sind jeweils mit 10 und 11 bezeichnet. Der Block 12 enthält einen Leseverstärker und eine Einschreibschaltung, die wahlweise an ein über die Spaltendecodierung 10 ausgewähltes Datenleitungspaar L1, L1ʹ anschaltbar sind. Analog dazu enthält ein weiterer Block 13 einen Leseverstärker und eine Einschreibschaltung, die wahlweise an ein über die Spaltendecodierung 11 ausgewähltes Datenleitungspaar L2, L2ʹ angeschaltet werden können. Der Eingang der Einschreibschaltung von 12 ist ebenso wie der Ausgang des Leseverstärkers desselben Blocks über eine Ein/Ausgangsleitung 14 mit DEA1 verbunden, der Eingang der Einschreibschaltung sowie der Ausgang des Leseverstärkers des Blocks 13 über eine Ein/Ausgangsleitung 15 mit DEA2. Bei nicht vollständiger Spaltendekodierung können DEA1, DEA2 jeweils auch aus einer Vielzahl von Ein/Ausgängen mit entsprechenden Ein/Ausgangsleitungen 14, 15 bestehen. Die Blöcke 12, 13 müssen dann entsprechend eine Vielzahl von Leseverstärkern und Einschreibschaltungen enthalten.

Bei der Adressierung einer Speicherzelle zum Zwecke des Einschreibens oder Auslesens eines Signals über DEA1 bewirkt ein dem Eingang AZ1 der Zeilendecodierung 8 zugeführtes Adressensignal, daß aus den Wortleitungen WL_{P1} eine bestimmte Wortleitung WL1 ausgewählt wird. Weiterhin bewirkt ein dem Eingang AS1 der Spaltendecodierung 8 zugeführtes Adressensignal, daß aus den Datenleitungspaaren LP_{P1} ein bestimmtes Paar L1, L1ʹ ausgewählt wird. Schließlich wird dem Eingang WR1 des Blocks 10 ein Signal zugeführt, das im Block 12 die Anschaltung des Leseverstärkers oder der Einschreibeschaltung an das ausgewählte Datenleitungspaar veranlaßt. In derselben Weise erfolgt die Adressierung einer Speicherzelle zum Zwecke des Einschreibens oder Auslesens eines Signals über DEA2 mit Hilfe von Adressensignalen, die den Eingängen AZ2 von 9 und AS2 von 11 zugeführt werden, und einem dem Eingang WR2 zugeführten Signal, das im Block 13 die Anschaltung des Leseverstärkers oder der Einschreibschaltung an das ausgewählte Datenleitungspaar L2, L2ʹ veranlaßt.

Bei einem Auslese- oder Einschreibvorgang für eine Speicherzelle gemäß Fig. 2 können von den Wortleitungen WL1 und WL2 entweder eine oder beide gleichzeitig adressiert sein, so daß entweder eines der Datenleitungspaare, z.B. L1 und L1ʹ, oder beide Datenleitungspaare L1, L1ʹ und L2, L2ʹ über die Transistoren T5, T6 bzw. T8, T7 mit den internen Knoten 4, 5 der Speicherzelle verbunden sind. Werden beide Wortleitungen gleichzeitig adressiert, so kann es zu den oben erwähnten Konfliktfällen beim Einschreiben von Signalen kommen.

Vor dem Auslesen eines gespeicherten Signals werden alle Datenleitungspaare LP_{P1} bzw. LP_{P2} mit einem vorgegebenen Potential beaufschlagt, was für die Datenleitungspaare LP_{P1} über eine Vorladeschaltung 16 und für die Datenleitungspaare LP_{P2} über eine Vorladeschaltung 17 erfolgt. Diese Vorladeschaltungen enthalten beispielsweise p-Kanal-Transistoren, deren Drainanschlüsse mit den einzelnen Datenleitungen verbunden sind, während ihre Sourceanschlüsse mit der Versorgungsspannung beschaltet sind. Die Steueranschlüsse der p-Kanal-Transistoren der Vorladeschaltung 16 sind dabei mit einem Eingang 18 verbunden, die Steueranschlüsse der p-Kanal-Transistoren der Vorladeschaltung 17 mit einem Eingang 19.

Zur Erklärung des Auslesevorgangs genügt es, ein Datenleitungspaar, z.B. L1 und L1ʹ, bei adressierter Wortleitung WL1 zu betrachten. L1, L1ʹ seien dabei durch die Vorladeschaltung auf die Versorgungsspannung vorgeladen. Bei einer gespeicherten "1" liegen der Knoten 4 z.B. auf der Versorgungsspannung und der Knoten 5 auf dem Bezugspotential. Das Auslesen der gespeicherten "1" läuft nun so ab, daß die Datenleitung L1ʹ über den Transistor T6 auf das Bezugspotential entladen wird, während die Datenleitung L1 auf der Versorgungsspannung verbleibt. Das entstehende Differenzsignal wird über den Leseverstärker des Blocks 12 als "1" bewertet und am Ein/Ausgang DEA1 ausgegeben. Beim Einschreiben einer "0" über den Ein/Ausgang DEA1 wird das ausgewählte Leitungspaar L1, L1ʹ über die Einschreibschaltung des Blocks 12 derart beaufschlagt, daß L1 auf das Bezugspotential gelangt und L1ʹ mit der Versorgungsspannung beschaltet wird. Die Potentiale an L1 und L1ʹ werden dann über die Transistoren T5 und T6 auf die Knoten 4 und 5 der Speicherzelle übertragen. Das Auslesen und Einschreiben von Signalen bei adressierter Wortleitung WL2 läuft entsprechend über das Datenleitungspaar L2, L2ʹ, den Block 13 und den mit DEA2 bezeichneten Ein/Ausgang für Daten ab.

Eine Taktschaltung 20, deren Eingang T mit einer externen Spannung U_{T} belegt ist, dient dazu, von U_{T} interne Taktspannungen U_{D1}, U_{V1}, U_{D2} und U_{V2} abzuleiten. U_{D1} veranlaßt dabei eine Wirksamschaltung der Zeilendecodierung 8 und der Spaltendecodierung 10, d.h. der Adreßsteuerung für den Ein/Ausgang DEA1, während U_{V1} die Vorladeschaltung 16 über deren Eingang 18 wirksam schaltet. Andererseits veranlaßt U_{D2} eine Wirksamschaltung der Zeilendecodierung 9 und der Spaltendecodierung 11, d.h. der Adreßsteuerung für den Ein/Ausgang DEA2, während U_{V2} die Vorladeschaltung 17 über deren Eingang 19 wirksam schaltet.

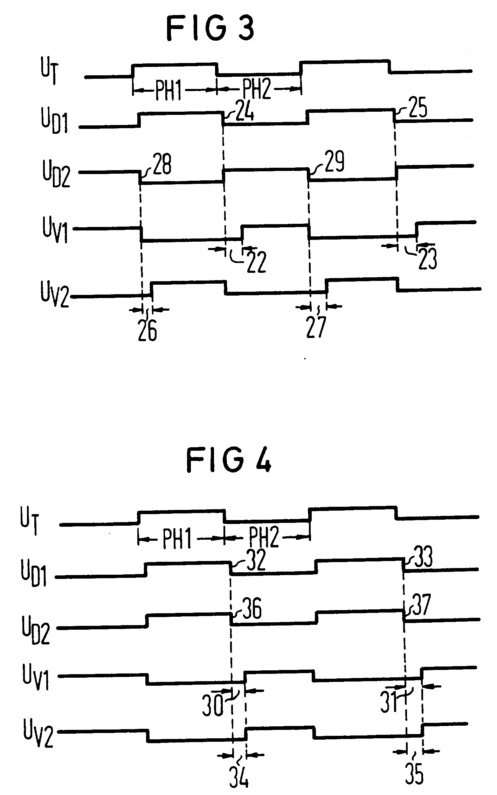

Der zeitliche Verlauf der genannten Taktspannungen, die jeweils zwischen einem der Bezugsspannung entsprechenden unteren Spannungswert und einem der Versorgungsspannung entsprechenden oberen Spannungswert alternieren, ist in Fig. 3 dargestellt. Während des Auftretens der oberen Spannungswerte von U_{V1} und U_{V2} sind jeweils die Vorladeschaltungen 16 und 17 wirksam geschaltet, während des Auftretens der oberen Spannungswerte von U_{D1} und U_{D2} jeweils die Adreßsteuerungen für die Ein/Ausgänge DEA1 und DEA2.

Zweckmäßigerweise wird dafür gesorgt, daß jeder Anstieg der Taktspannung U_{V1} vom unteren auf den oberen Spannungswert, bei dem die Vorladeschaltung 16 aktiviert wird, um eine durch die Doppelpfeile 22 und 23 angedeutete Zeitspanne gegenüber den vorhergehenden Rückflanken 24 und 25 von U_{D1}, durch die die Adreßsteuerung für DEA1 deaktiviert wird, verzögert wird. Die entsprechenden Spannungsanstiege bei U_{V2} treten um die durch die Doppelpfeile 26 und 27 angedeuteten Zeitspannen gegenüber den Rückflanken 28 und 29 von U_{D2} verzögert auf. Hierdurch wird sichergestellt, daß die Adreßsteuerung für einen Ein/Ausgang, z.B. DEA1, deaktiviert wird, bevor die Vorladung der diesem Ausgang zugeordneten Datenleitungspaare, z.B. LP_{P1}, beginnt.

Durch die Taktsteuerung gemäß Fig. 3 erfolgt eine wechselweise Ansteuerung der Adreßsteuerungen für DEA1 und DEA2 und der Vorladeschaltungen 16 und 17, wobei in einer ersten Taktphase PH1 von U_{T} die Adreßsteuerung 8 und 10 für DEA1 sowie die Vorladeschaltung 17 wirksam geschaltet sind, während in einer zweiten Taktphase PH2 die Adreßsteuerung 9 und 11 für DEA2 sowie die Vorladeschaltung 16 wirksam geschaltet sind. Beide Taktphasen ergänzen sich zu einer vollständigen Taktperiode von U_{T}. Bei dieser Betriebsweise der Schaltung ist jeweils die Adreßsteuerung des einen Ein/Ausgangs, z.B. DEA1, aktiviert, während die Datenleitungspaare, z.B. LP_{P2}, des anderen Ein/Ausgangs, z.B. DEA2, vorgeladen werden. Damit können die eingangs erwähnten Konfliktsituationen, die bei den herkömmlichen Dual-Port-RAMs durch logische Gatterschaltungen verhindert werden müssen, nicht mehr auftreten.

Gemäß der Erfindung ist die Taktschaltung 20 so ausgebildet, daß sie wahlweise auf einen anderen Betriebsmodus umschaltbar ist, bei dem eine Taktsteuerung der Adreßsteuerungen und der Vorladeschaltungen gemäß Fig. 4 erfolgt. Zu diesem Zweck ist beispielsweise ein Eingang SM der Taktschaltung 20 mit einem Signal U_{SM} belegt, das einen Betriebsmodus gemäß Fig. 3 gewährleistet. Wird dann U_{SM} abgeschaltet, so arbeitet die Taktschaltung 20 in einem Betriebsmodus gemäß Fig. 4 Die in letzterem Fall auftretenden Zeitabhängigkeiten der internen Taktspannungen U_{D1}, U_{D2}, U_{V1} und U_{V2} sind wieder unterhalb der externen Taktspannung U_{T} dargestellt. Wie hieraus entnehmbar ist, erfolgt in diesem Betriebsmodus eine gemeinsame Ansteuerung der Adreßsteuerungen für die DEA1 und DEA2 einerseits und der Vorladeschaltungen 16 und 17 andererseits, wobei in der ersten Taktphase PH1 von U_{T} die Adreßsteuerungen 8 und 10 für DEA1 sowie 9 und 11 für DEA2 wirksam geschaltet sind, während in der zweiten Taktphase PH2 die Vorladeschaltungen 16 und 17 gleichzeitig wirksam geschaltet sind. Dabei sind jeweils die Adreßsteuerungen beider Ein/Ausgänge oder beide Vorladeschaltungen 16 und 17 gleichzeitig aktiviert. Hierbei ergibt sich der Vorteil, daß die Vorladephase PH2 wahlweise kürzer gemacht werden kann als die Adressierphase 1, so daß die durch die Taktperiode der externen Taktspannung U_{T} bestimmte Zykluszeit des Halbleiterspeichers gegenüber der, die bei einer Taktsteuerung gemäß Figur 3 erforderlich ist, verkleinert werden kann. Wegen der Verkleinerung der Zykluszeit ergeben sich für einen Halbleiterspeicher, dessen Taktschaltung in dem letzteren Betriebsmodus arbeitet, vorteilhafte Einsatzmöglichkeiten bei Hochgeschwindigkeitsprozessoren.

Die eingangs erwähnten Konfliktsituationen, die sich beim Einschreiben von zwei unterschiedlichen Signalen in ein und dieselbe über beide Ein/Ausgänge gleichzeitig adressierte Speicherzelle ergeben, werden bei der vorstehend beschriebenen Erfindung, deren Taktschaltung wahlweise auch in dem durch Fig. 4 angedeuteten Betriebsmodus arbeitet, mittels logischer Gatterschaltungen ausgeschlossen, die z.B. ein gleichzeitiges Einschreiben von zwei unterschiedlichen Signalen in ein und dieselbe Speicherzelle verhindern.

Auch in dem Betriebsmodus gemäß Fig. 4 sind die Anstiege der Taktspannung U_{V1} vom unteren auf den oberen Spannungswert vorteilhafterweise um die durch die Doppelpfeile 30 und 31 angedeuteten Zeitspannen gegenüber den vorhergehenden Rückflanken 32 und 33 von U_{D1} verzögert. In analoger Weise liegen die Vorderflanken von U_{V2} um die Zeitspannen 34 und 35 hinter den Rückflanken 36 und 37 von U_{D2}. Hierdurch wird erreicht, daß die Adreßsteuerungen der Ein/Ausgänge deaktiviert sind, bevor die Vorladung der Datenleitungspaare beginnt.

Eine bevorzugte schaltungstechnische Durchbildung der Taktschaltung 20 ist in Fig. 5 dargestellt. Hierbei handelt es sich um eine Taktschaltung, die gemäß der Weiterbildung der Erfindung wahlweise auf eine von zwei Betriebsmoden umschaltbar ist. Sie enthält zwei NAND-Gatter 38, 39, deren erste mit T und SM bezeichnete Eingänge jeweils den gleichbezeichneten Eingängen von Fig. 1 entsprechen. Die zweiten Eingänge von 38 und 39 sind mit einem Anschluß CS verbunden. Der Ausgang von 38 ist über einen Inverter 40 mit einem Schaltungsknoten 41 verbunden, der über einen Verstärker 42 mit einem Ausgang 43 in Verbindung steht. Der Knoten 41 ist andererseits mit dem ersten Eingang eines NOR-Gatters 44 direkt beschaltet und mit dem zweiten Eingang desselben über einen Verstärker 45 verbunden. Der Ausgang von 44 ist über einen Verstärker 46 an einen Ausgang 47 geführt. Weiterhin ist der Knoten 41 über einen Inverter 48 und ein Transmissions-Gatter 49 mit einem Knoten 50 verbunden, der seinerseits über einen Verstärker 51 mit einem Ausgang 52 in Verbindung steht. Der Knoten 50 ist mit dem ersten Eingang eines NOR-Gatters 53 unmittelbar verbunden sowie über einen Verstärker 54 mit dem zweiten Eingang dieses Gatters beschaltet, dessen Ausgang über einen Verstärker 55 an einen Ausgang 56 gelegt ist.

Das Transmissions-Gatter 49 besteht aus einem n-Kanal-Transistor T9 und einem p-Kanal-Transistor T10, die mit ihren Source-Drain-Strecken jeweils zwischen den Ausgang des Inverters 48 und den Knoten 50 eingefügt sind. Der Gateanschluß von T9 liegt dabei am Ausgang eines Inverters 57, der dem Ausgang des NOR-Gatters 39 nachgeschaltet ist, während der Gateanschluß von T10 am Ausgang eines Inverters 58 liegt, der dem Inverter 57 nachgeschaltet ist. Schließlich ist noch ein weiteres Transmissions-Gatter 59 vorgesehen, daß aus einem n-Kanal-Transistor T11 und einem p-Kanal-Transistor T12 gebildet ist, die mit ihren Source-Drain-Strecken zwischen die Knoten 41 und 50 eingefügt sind. Der Gateanschluß von T11 liegt dabei am Ausgang des Inverters 58, der Gateanschluß von T12 am Ausgang des Inverters 57.

Unter der Annahme, daß der Anschluß CS mit einer logischen "1" beschaltet ist und am Eingang SM ein Signal U_{SM} anliegt, das ebenfalls einer logischen "1" entspricht, ergibt sich am Ausgang von 39 eine logische "0", am Ausgang von 57 eine logische "1" und am Ausgang von 58 wieder eine logische "0". Hierdurch wird das Transmissions-Gatter 49 leitend geschaltet, während das Transmissions-Gatter 59 gesperrt bleibt. Jeder Taktimpuls von U_{T} wird an den Ausgang des Inverters 40 und damit an den Ausgang 43 nicht invertiert übertragen, wobei am Ausgang 43 die interne Taktspannung U_{D1} abgreifbar ist. Am Ausgang 47 steht die inverse Spannung zu U_{D1} als Taktspannung U_{V1} zur Verfügung, wobei durch die Laufzeit des Verstärkers 45 die Zeitverzögerungen 22 und 23 entstehen. Der Inverter 48 bewirkt, daß am Ausgang 52 eine zu U_{D1} inverse Spannung auftritt, die die Taktspannung U_{D2} darstellt. Schließlich ist am Ausgang 56 die Taktspannung U_{V2} abgreifbar, wobei die Verzögerungen 26 und 27 durch die Laufzeit des Verstärkers 54 entstehen. Damit werden über die Ausgänge 43, 47, 52 und 56 die Taktspannungen gemäß Fig. 3 abgeleitet.

Wird nun das Signal U_{SM} vom Anschluß SM abgeschaltet bzw. liegt an SM eine "0" an, so wird das Transmissions-Gatter 59 anstelle von 49 leitend geschaltet, während das Gatter 49 gesperrt wird. Damit sind die Knoten 41 und 50 miteinander leitend verbunden, so daß die Taktspannungen U_{D2} und U_{V2} in ihrem zeitlichen Verlauf den Taktspannungen U_{D1} und U_{V1} jeweils vollständig entsprechen. Dabei ergibt sich der durch Fig. 4 dargestellte Betriebsmodus der Taktschaltung 20.

Legt man an den Anschluß CS eine logische "0" an, so ergeben sich unabhängig von der Taktspannung U_{T} an den Ausgängen 47 und 56 jeweils "1"-Signale, an den Ausgängen 43 und 52 jedoch "0"-Signale, so daß eine Vorladung sämtlicher Datenleitungspaare LP_{P1} und LP_{P2} erfolgt.

## Patentansprüche

1. Halbleiterspeicher mit wahlfreiem Zugriff über zwei getrennte Ein/Ausgänge für Daten (DEA1, DEA2), bei dem jedem dieser Ein/Ausgänge eine eigene Adreßsteuerung (8, 10; 9, 11) und ein eigener Schreib/Lesepfad (12, 13) zugeordnet sind, und bei dem die die einzelnen Speicherzellen mit den Schreib/Lesepfaden (12, 13) verbindenden Datenleitungen (L1, L1', L2, L2') mit einem vorgegebenen Potential beaufschlagbar sind, bei dem eine erste Vorladeschaltung (16) zur Belegung der dem ersten Ein/Ausgang (DEA1) zugeordneten Datenleitungen (L1, L1') mit dem vorgegebenen Potential und eine zweite Vorladeschaltung (17) zur entsprechenden Belegung der dem zweiten Ein/Ausgang (DEA2) zugeordneten Datenleitungen (L2, L2') vorgesehen sind und bei dem eine mit einer Taktspannung (U_{T)} belegte Taktschaltung (20) vorhanden ist, über die die Adreßsteuerungen (8, 10; 9, 11) und die Vorladeschaltungen (16, 17) jeweils wechselweise angesteuert werden, so daß in einer ersten Taktphase (PH1) die Adreßsteuerung (8, 10) des ersten Ein/Ausgangs (DEA1) und die Vorladeschaltung (17) für die dem zweiten Ein/Ausgang (DEA2) zugeordneten Datenleitungen (L2, L2') und in einer zweiten Taktphase (PH2) die Adreßsteuerung (9, 11) des zweiten Ein/Ausgangs (DEA2) und die Vorladeschaltung (16) für die dem ersten Ein/Ausgang (DEA1) zugeordneten Datenleitungen (L1, L1') wirksam geschaltet sind,
**dadurch gekennzeichnet,**
daß die Taktschaltung (20) auf einen anderen Betriebsmodus umschaltbar ist, in dem sie die Adreßsteuerungen (8, 10; 9, 11) und die Vorladeschaltungen (16, 17) jeweils gemeinsam ansteuert, so daß in der ersten Taktphase (PH1) die Adreßsteuerungen (8, 10; 9, 11) beider Ein/ Ausgänge (DEA1, DEA2) und in der zweiten Taktphase (PH2) beide Vorladeschaltungen (16, 17) wirksam geschaltet sind.

2. Halbleiterspeicher nach Anspruch 1,
**dadurch gekennzeichnet,**
daß die Wirksamschaltung der Adreßsteuerung (8, 10) eines Ein/Ausgangs (DEA1) durch eine Wirksamschaltung der diesem zugeordneten Adreßdekoder erfolgt, wobei zusätzlich eine Wirksamschaltung der in dem zugeordneten Schreib/Lesepfad (12) vorgesehenen Lese- oder Einschreibschaltung veranlaßt wird.

3. Halbleiterspeicher nach Anspruch 1 oder 2,
**dadurch gekennzeichnet,**
daß in Serie zu den Taktschaltungsausgängen (47, 56) für die Vorladeschaltungen (16,, 17) Verzögerungselemente (45, 54) angeordnet sind, die eine Verzögerung (22) der Wirksamschaltung einer Vorladeschaltung (16) nach der vorhergehenden Unwirksamschaltung (24) der Adreßsteuerung (8, 10) des ihr zugeordneten Ein/Ausgangs (DEA1) veranlassen.

4. Halbleiterspeicher nach einem der Ansprüche 1 bis 3,
**dadurch gekennzeichnet,**
daß die Taktschaltung (20) zwei NAND-Gatter (38, 39) aufweist, deren erste Eingänge (T, SM) jeweils mit der Taktspannung (U_{T}) und einem Signal (U_{SM}) zur Betriebsmodenumschaltung beschaltet sind und deren zweite Eingänge an einem gemeinsamen Anschluß (CS) liegen, daß der Ausgang des einen NAND-Gatters (38) über einen ersten Inverter (40) mit einem ersten Schaltungsknoten (41) verbunden ist, der über einen ersten Verstärker (42) mit einem ersten Taktschaltungsausgang (43) in Verbindung steht, daß der erste Schaltungsknoten (41) mit dem ersten Eingang eines ersten NOR-Gatters (44) direkt und mit dem zweiten Eingang desselben über einen zweiten Verstärker (45) verbunden ist, daß der Ausgang des ersten NOR-Gatters über einen dritten Verstärker (46) mit einem zweiten Taktschaltungsausgang (47) verbunden ist, daß dem Ausgang des anderen NAND-Gatters (39) eine Serienschaltung eines zweiten und dritten Inverters (57, 58) nachgeschaltet ist, daß der erste Schaltungsknoten (41) über einen vierten Inverter (48) und ein erstes Transmissions-Gatter (49) mit einem zweiten Schaltungsknoten (50) verbunden ist, daß die Steuereingänge des ersten Transmissions-Gatters (49) mit den Ausgängen des zweiten und dritten Inverters (57, 58) beschaltet sind, daß ein zweites, von den Ausgängen des zweiten und dritten Inverters (57, 58) gesteuertes Transmissions-Gatter (59) vorhanden ist, welches den ersten Schaltungsknoten (41) mit dem zweiten Schaltungsknoten (50) verbindet, daß der zweite Schaltungsknoten (50) über einen vierten Verstärker (51) mit einem dritten Taktschaltungsausgang (52) in Verbindung steht, daß der zweite Schaltungsknoten (50) mit dem ersten Eingang eines zweiten NOR-Gatters (53) direkt und mit dem zweiten Eingang desselben über einen fünften Verstärker (54) verbunden ist, daß der Ausgang des zweiten NOR-Gatters (53) über einen sechsten Verstärker (55) mit einem vierten Schaltungsausgang (56) beschaltet ist, und daß am ersten und dritten Taktschaltungsausgang jeweils Taktspannungen zur Ansteuerung der Adreßsteuerung (8, 10; 9, 11) der beiden Ein/Ausgänge (DEA1, DEA2) und am zweiten und vierten Taktschaltungsausgang jeweils Taktspannungen zur Ansteuerung der Vorladeschaltungen (16, 17) für die den Ein/Ausgängen (DEA1, DEA2) zugeordneten Datenleitungen (L1, L1', L2, L2') abgreifbar sind.

## Claims

1. Semiconductor memory with random access via two separate input/output terminals for data (DEA1, DEA2), in which each of said input/output terminals is assigned its own address controller (8, 10; 9, 11) and its own read/write path (12, 13), and in which a predetermined potential can be applied to the data lines (L1, L1', L2, L2') connecting the individual memory cells to the read/write paths (12, 13), in which a first pre-loading circuit (16) is provided for application of the pre-determined potential to the data lines (L1, L1') assigned to the first input/output terminal (DEA1) and a second pre-loading circuit (17) is provided for the corresponding application to the data lines (L2, L2') assigned to the second input/output terminal (DEA2), and in which a clock circuit (20) which receives a clock voltage (U_{T}) is present, via which the address controllers (8, 10; 9, 11) and the pre-loading circuits (16, 17) are driven alternately in each case, so that the address controller (8, 10) of the first input/output terminal (DEA1) and the pre-loading circuit (17) for the data lines (L2, L2') assigned to the second input/output terminal (DEA2) are activated in a first clock phase (PH1), and the address controller (9, 11) of the second input/output terminal (DEA2) and the pre-loading circuit (16) for the data lines (L1, L1') assigned to the first input/output terminal (DEA1) are activated in a second clock phase (PH2), characterised in that the clock circuit (20) can be switched over into another operating mode by driving the address controllers (8, 10; 9, 11) and the pre-loading circuits (16, 17) jointly in each case so that the address controllers (8, 10; 9, 11) of both input/output terminals (DEA1, DEA2) are activated in the first clock phase (PH1) and both pre-loading circuits (16, 17) are activated in the second clock phase (PH2).

2. Semiconductor memory according to Claim 1, characterised in that the activation of the address controller (8, 10) of an input/output terminal (DEA1) is effected by an activation of its associated address decoder, an activation of the read or write circuit provided in the associated read/write path (12) being initiated in addition.

3. Semiconductor memory according to Claim 1 or 2, characterised in that delay elements (45, 54) are arranged in series with the clock circuit outputs (47, 56) for the pre-loading circuits (16, 17), which delay elements initiate a delaying (22) of the activation of a pre-loading circuit (16) after the preceding deactivation (24) of the address controller (8, 10) of its associated input/output terminal (DEA1).

4. Semiconductor memory according to one of Claims 1 to 3, characterised in that the clock circuit (20) has two NAND gates (38, 39), the first inputs (T, SM) of which are connected in each case to the clock voltage (U_{T}) and a signal (U_{SM}) for switching over the operating mode, and the second inputs of which are connected to a common terminal (CS), in that the output of the one NAND gate (38) is connected via a first inverter (40) to a first circuit node (41), which is connected via a first amplifier (42) to a first clock circuit output (43), in that the first circuit node (41) is connected directly to the first input of a first NOR gate (44) and via a second amplifier (45) to the second input thereof, in that the output of the first NOR gate is connected via a third amplifier (46) to a second clock circuit output (47), in that a series circuit comprising a second and third inverter (57, 58) is connected downstream of the output of the other NAND gate (39), in that the first circuit node (41) is connected via a fourth inverter (48) and a first transmission gate (49) to a second circuit node (50), in that the control inputs of the first transmission gate (49) are connected to the outputs of the second and third inverter (57, 58), in that a second transmission gate (59) controlled by the outputs of the second and third inverter (57, 58) is present, which transmission gate connects the first circuit node (41) to the second circuit node (50), in that the second circuit node (50) is connected via a fourth amplifier (51) to a third clock circuit output (52), in that the second circuit node (50) is connected directly to the first input of a second NOR gate (53) and via a fifth amplifier (54) to the second input thereof, in that the output of the second NOR gate (53) is connected via a sixth amplifier (55) to a fourth circuit output (56), and in that clock voltages for driving the address controller (8, 10; 9, 11) of the two input/output terminals (DEA1, DEA2) can be picked up in each case at the first and third clock circuit output, and clock voltages for driving the pre-loading circuits (16, 17) for the data lines (L1, L1', L2, L2') assigned to the input/output terminals (DEA1, DEA2) can be picked up in each case at the second and fourth clock circuit output.

## Revendications

1. Mémoire à semiconducteurs à accès au choix par l'intermédiaire de deux entrées/sorties distinctes pour des données (DEA1,DEA2), dans laquelle à chacune de ces entrées/sorties sont associées une unité propre de commande d'adresses (8,10;9,11) et une voie propre d'écriture/lecture (12,13), et dans laquelle les lignes de transmission de données (L1,L1',L2,L2') reliant cellules mémoire aux voies d'écriture/lecture (12,13), peuvent être chargées par un potentiel prédéterminé, et dans laquelle il est prévu un premier circuit de précharge (16) pour appliquer le potentiel prédéterminé aux lignes de transmission de données (L1,L1') associées à la première entrée/sortie (DEA1), et un second circuit de précharge (17) pour appliquer le potentiel prédéterminé aux lignes de transmission de données (L2,L2') associées à la seconde entrée/sortie (DEA2), et dans laquelle il est prévu un circuit de cadence (20), qui applique une tension de cadence (U_{T}) et au moyen duquel les unités de commande d'adresses (8,10; 9,11) et les circuits de précharge (16,17) sont respectivement commandés en alternance de manière à rendre opérante, pendant une première phase de cadence (PH1), l'unité de commande d'adresses (8,10) de la première entrée/sortie (DEA1) et le circuit de précharge (17) pour les lignes de transmission de données (L2,L2') associées à la seconde entrée/sortie (DEA2) et que, pendant une seconde phase de cadence (PH2), l'unité de commande d'adresses (9,11) de la seconde entrée/sortie (DEA2) et le circuit de précharge (16) pour les lignes de transmission de données (L1,L1') associées à la première entrée/sortie (DEA1), caractérisée par le fait que le circuit de cadence (20) peut être commuté sur un autre mode de fonctionnement, dans lequel il commande en commun les unités de commande d'adresses (8,10; 9,11) et les circuits de précharge (16,17), de manière à render opérante, pendant la première phase de cadence (PH1), les unités de commande d'adresses (8,10; 9,11) des deux entrées/sortie (DEA1,DEA2) et, pendant la seconde phase de cadence (PH2), les deux circuits de précharge (16,17).

2. Mémoire à semiconducteurs suivant la revendication 1, caractérisée par le fait que l'unité de commande d'adresses (8,10) d'une entrée/sortie (DEA1) est rendue opérante en rendant opérant le décodeur d'adresses associé à cette entrée/sortie, le circuit de lecture ou d'écriture prévu dans la voie associée d'écriture/lecture (12) étant, en outre, rendue opérant.

3. Mémoire à semiconducteurs suivant la revendication 1 ou 2, caractérisée par le fait qu'en série avec les sorties (47,56) du circuit de cadence prévues pour les circuits de précharge (16,17), sont montés des éléments de retardement (45,54), qui provoquent un retard (22) de la mise en opération d'un circuit de précharge (16) après que l'unité de commande d'adresses (8,10) de l'entrée/sortie (DEA1) qui lui est associée a été rendue au préalable inopérante.

4. Mémoire à semiconducteurs suivant les revendications 1 à 3, caractérisée par le fait que le circuit de cadence (20) comporte deux portes NON-ET (38,39), dont les premières entrées (T,SM) reçoivent respectivement la tension de cadence (U_{T}) et un signal (U_{SM}) pour une commutation du mode de fonctionnement et dont des secondes entrées sont reliées à une borne (CS) commune, que la sortie des portes NON-ET (38) est reliée, par l'intermédiaire d'un premier inverseur (40), à un premier noeud (41) du circuit, qui est relié, par l'intermédiaire d'un premier amplificateur (42), à une première sortie (43) du circuit de cadence, que le premier noeud (41) du circuit est relié directement à la première entrée d'une première porte NON-OU (44) et est relié à la seconde entrée de cette dernière par l'intermédiaire d'un deuxième amplificateur (45), que la sortie de la première porte NON-OU est reliée, par l'intermédiaire d'un troisième amplificateur (46), à une deuxième sortie (47) du circuit de cadence, qu'en aval de la sortie de l'autre porte NON-ET (39) est monté un circuit série formé d'un deuxième et d'un troisième inverseurs (57,58), que le premier noeud (41) du circuit est relié, par l'intermédiaire d'un quatrième inverseur (48) et d'une première porte de transmission (49), à un second noeud (50) du circuit, que les entrées de commande de la première porte de transmission (49) sont reliées aux sorties du deuxième et du troisième inverseurs (57,58), qu'il est prévu une seconde porte de transmission (59), qui est commandée par les sorties du deuxième et du troisième inverseurs (57,58) et qui relie le premier noeud (41) du circuit au second noeud (50) du circuit, que le second noeud (50) du circuit est relié, par l'intermédiaire d'un quatrième amplificateur (51), à une troisième sortie (52) du circuit de cadence, que le second noeud (50) du circuit est relié directement à la première entrée d'une seconde porte NON-OU (53) et à la seconde entrée de cette dernière, par l'intermédiaire d'un cinquième amplificateur (54), que la sortie de la seconde porte NON-OU (53) est reliée, par l'intermédiaire d'un sixième amplificateur (55), à une quatrième sortie (56) du circuit, et que des tensions de cadence pour la commande de l'unité de commande d'adresses (8,10;9,11) des deux entrées/sorties (DEA1,DEA2) peuvent être prélevées sur la première et la troisième sorties du circuit de cadence et que des tensions de cadence pour la commande des circuits de précharge (16,17) pour les lignes de transmission de données (L1,L1',L2,L2') associées aux entrées/sortie (DEA1,DEA2), peuvent être prélevées sur la seconde et la quatrième sorties du circuit de cadence.
